# EUROPÄISCHE PATENTSCHRIFT

(11) **EP 0 292 671 B1**
(45) Veröffentlichungstag und Bekanntmachung des Hinweises auf die Patenterteilung: **20.01.1993**
(21) Anmeldenummer: 88105110.6
(22) Anmeldetag: 29.03.1988
(51) Int. Cl.: H05K 7/20

(54) **Lüftervorrichtung**
Ventilation device
Dispositif de ventilation

(30) Priorität: 26.05.1987 DE 3717796
(43) Veröffentlichungstag der Anmeldung: 30.11.1988
(73) Patentinhaber: Knürr Mechanik für die Elektronik AG, D-81829 München (DE)
(72) Erfinder: Simon, Peter, D-8000 München 21 (DE)
(74) Vertreter: Weber, Otto Ernst, Dipl.-Phys.

(56) Entgegenhaltungen:
- DE-A- 2 235 564
- DESIGN ENGINEERING. Januar 1983, LONDON GB Seite 73 - 83; SHARPE: "Cooling electronic equipment."

## Beschreibung

Die Erfindung betrifft eine Lüftervorrichtung und insbesondere einen Lüftereinschub gemäß Oberbegriff des Anspruches 1.

Eine Lüftervorrichtung gemäß dem Oberbegriff des Anspruchs 1 ist aus DE-A-2235564 bekannt.

Derartige Lüftervorrichtungen und Lüftereinschübe werden vor allen Dingen zur Wärmeableitung von elektronischen Baugruppen in EDV-Anlagen oder ähnlichen schrankartig installierten Elektronikeinheiten verwendet.

Frontansaugende Lüftereinschübe haben dabei den Vorteil, daß sie keinen weiteren Lufteinlaß, z.B. im Boden- oder Rückseitenbereich, benötigen. Vielmehr ist es bei diesen Lüftereinschüben mit Frontansaugung möglich, den Einschub als separate Einheit in der gewünschten Höhe in den Elektronikschrank einzuschieben, ohne daß hierfür Luftzufuhrbereiche erforderlich sind. Der Lüftereinschub mit Frontansaugung saugt die Kühlluft frontseitig am Gehäuse an und gibt sie im wesentlichen aufgrund seiner Axiallüfter in vertikaler Richtung oder in schräger Richtung mit Umlenkung an der Rückwand des entsprechenden Schrankes ab.

Unter dem vorausgehend angeführten Begriff des Axiallüfters wird hierbei ein Lüfteraggregat verstanden, das eine in sich geschlossene Baugruppe mit Antriebsmotor Ventilatorflügeln und Gehäuse ist, wobei die Luftabstrahlung in axialer Richtung erfolgt. Bei einem Einbau der Lüfter senkrecht zur Gehäuseoberseite wird daher die frontal angesaugte Luft um 90° umgelenkt und vertikal den zu kühlenden elektronischen Baugruppen zugeführt.

Bei den Lüftereinschüben mit Frontansaugung und Axiallüftern war es bisher ein großer Nachteil gewesen, daß unabhängig von der Bauhöhe des Lüftereinschubes nur der rückwärtige Bereich der Gehäuseoberseite mit einzelnen Lüftern besetzt werden konnte. Mit anderen Worten die vordere Gehäuseoberfläche im Bereich der Frontseite bzw. der Ansaugöffnung des Lüftereinschubes wies stets keine Lüfter auf. Welche Gründe hierfür im einzelnen ausschlaggebend waren, kann schwer nachvollzogen werden.

Es darf jedoch angenommen werden, daß sich durch die Vergrößerung der im Ansaugbereich angebrachten Luftfilterfläche, eine Strömungsdynamik einstellte, die erst im rückwärtigen Bereich des Lüftereinschubes eine optimale Anordnung der einzelnen Axiallüfter mit vertikaler Abstrahlung zuließ.

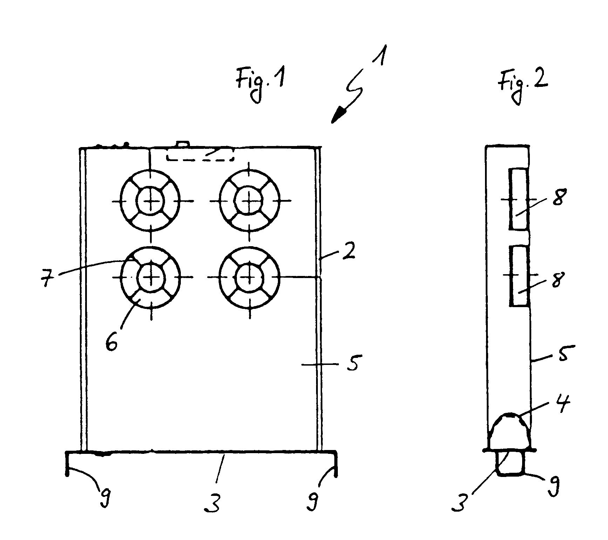

Beispielsweise ist in den Figuren 1 und 2 ein herkömmlicher Lüftereinschub dargestellt, der einen beutelartig in das Gehäuse hineinragenden Filtereinsatz aufweist. Gerade anhand dieses Beispiels erscheint es plausibel, daß die Luftströmung erst in der rückwärtigen Hälfte des Lüftereinschubes sich so verhält, daß eine gute Ansaugwirkung für Axiallüfter mit 90° Umlenkung der angesaugten Luft gegenüber der abgegebenen Luft vorhanden ist. Analoge Ausführungsformen mit allein im rückwärtigen Bereich des Gehäuses vorgesehenen Axiallüftern sind auch bei schräg gestelltem Luftfilters anzutreffen.

Diese bisherige Realisierungsmöglichkeit frontansaugender Lüftereinschübe mit Axiallüftern bringt für den Fachmann erkennbar die Nachteile, daß elektronische Baugruppen und Wärmenester, die vertikal über dem Lüftereinschub im Bereich der Frontseite des Gehäuses lokalisiert sind, nicht effektiv genug gekühlt werden können. Dies deshalb, da im vorderen Bereich der Gehäuseoberfläche,vergleichbar mit einem technischen Vorurteil der Fachwelt, keine Axiallüfter angebracht wurden.

Man ging daher den Weg, in Anwendungsfällen, in denen eine Kühlung und Luftabgabe im Bereich der vorderen Seite des Elektronikschrankes bzw. der Ansaugöffnung erforderlich war, ein Querstromgebläse einzusetzen. Ein derartiges Querstromgebläse besteht üblicherweise aus einem dicht hinter der Frontansaugöffnung des Lüftereinschubes angeordnetem Radiallüfter. Der Begriff des Radiallüfters wird hierbei so definiert, daß die Ansaugung und Abstrahlung des Radiallüfters in radialer Richtung zu dessen Achse erfolgt. Die Luftumlenkung des Radiallüfters bzw. Querstromgebläses kann üblicherweise auch 90° betragen, wobei aber auch andere Winkel möglich sind.

Mit derartigen Querstromgebläsen konnte man daher bisher auch die im Frontbereich angeordneten Baugruppen, die vertikal über dem Querstromgebläse vorgesehen waren, gut kühlen. Nachteilig jedoch war, daß ein derartiges Querstromgebläse für Kühlung im rückwärtigen Bereich eines entsprechenden Elektronikschrankes nicht geeignet war oder spezielle Führungskanäle erforderlich machte.

Es bestand daher eine technische Realisierungslücke bei frontansaugenden Lüftereinschüben mit Axiallüftern eine optimale Kühlung im Bereich der gesamten über der Gehäuseoberfläche angeordneten Baugruppen zu erreichen.

Der Erfindung liegt daher die **Aufgabe** zugrunde, eine Lüftervorrichtung und speziell einen gattungsgemäßen Lüftereinschub mit möglichst großer Filterfläche auszulegen, wobei eine wirkungsvolle Abstrahlung, gegebenenfalls auch bei variabler Lüfteranordnung, im gesamten Bereich der oberen Gehäusefläche des Lüftereinschubes möglich sein sollte.

Diese Aufgabe wird erfindungsgemäß durch die Merkmale des kennzeichnenden Teils des Anspruches 1 gelöst.

Ein wesentlicher Erfindungsgedanke kann daher darin gesehen werden, das hinter der frontseitigen Einlaßöffnung des Lüftereinschubes vorgesehene Luftfilter in einer Ebene anzuordnen, die vom oberen Bereich der Einlaßöffnung schräg in das Gehäuse des Lüftereinschubes hineinreicht und bis zum Gehäuseboden angeordnet ist. In dieser Ausführungsform hat es sich in empirischen Versuchen gezeigt, daß die Anordnung der Axiallüfter im wesentlichen senkrecht zur oberen Gehäusefläche bis in den Frontbereich des Lüftereinschubes verwirklicht werden kann, ohne daß hierdurch eine Beeinträchtigung der Ansaugwirkung und Abstrahlwirkung der oder des vorderen Lüfters feststellbar ist.

Diese erfindungsgemäße Realisierung eines Lüftereinschubes mit Frontansaugung und vertikaler Abstrahlung über seinen gesamten Oberflächenbereich ist nach derzeitigen Erkenntnissen erst dadurch möglich geworden, daß man das Luftfilter als ebene Fläche schräg anordnet und zudem die technische Lücke überspringt, im vorderen Bereich benachbart zur Frontfläche des Lüftereinschubes "keine" Lüfter anzuordnen. Die schräge Filterebene, die relativ weit in das Gehäuse hineinragt und vorzugsweise in der rückwärtigen Hälfte endet, gestattet es offensichtlich auch bei mehrreihig in der Tiefe angeordneten Lüftern eine weitgehend gleichförmige Strömungsdynamik für die anzusaugende Luft zu erreichen. Vielleicht trägt gerade die Anordnung der vorderen Lüfter in bezug auf das schräge Luftfilter dazu bei, daß auch für die rückwärtigen Lüfter günstige Ansaugbedingungen bestehen.

Allerdings ist festzustellen, daß die genauen strömungsphysikalischen Gründe für die effektive und nahezu optimale Vertikalluftabstrahlung bei dem erfindungsgemäßen frontansaugenden Lüftereinschub noch unklar sind.

Die Anordnung des vordersten Lüfters bzw. der vordersten Reihe von Lüftern, dicht benachbart zur frontseitigen Ansaugöffnung und dem Luftfilter, ist dabei so zu verstehen, daß je nach Neigungswinkel des Luftfilters dieser Lüfter nur geringfügig beabstandet von der Filterebene vorgesehen werden kann. In der Regel kann daher mit dem vorderen Lüfter bzw. der der vorderen Frontseite benachbarten Lüfterreihe ein Abstand zur Frontseite des Gehäuses eingehalten werden, der vergleichbar ist mit dem der rückwärtigen Lüfter zur Rückseite des Gehäuses.

Mit der Schräganordnung des Luftfilters wird auch eine wesentlich größere Filterfläche erreicht, die bei vergleichbaren Umgebungs- und Ansaugbedingungen daher eine bessere Abreinigung der angesaugten Luft bzw. eine längere Betriebsphase ermöglicht. Der Austausch des über Führungsschienen leicht ein-oder auswechselbaren Luftfilters muß daher erst in größeren Zeitintervallen durchgeführt werden. In Abhängigkeit von der Gesamthöhe des Lüftereinschubes und der axialen Erstreckung der verwendeten Lüfter kann die vordere Kante des Luftfilters nahezu an der oberen Gehäusefläche beginnen. Sofern man den oder die vordersten Lüfter noch näher an die Frontöffnung heransetzen will, beginnt die frontseitige Ansaugfläche mit geringem Abstand unterhalb der oberen Gehäusefläche.

Die Erstreckung des Luftfilters über die vordere Gehäusehälfte in das Gehäuse hinein bringt in Abstimmung mit der axialen Tiefe der verwendeten Lüfter eine erheblich vergrößerte Filterfläche und ermöglicht es, den vorderen Lüfter in dichtem Abstand zur Frontseite im Lüftereinschub zu integrieren. Andere Anordnungen des Luftfilters, z.B. mit größerem oder kleinerem Neigungswinkel gegenüber der Bodenfläche des Gehäuses sind möglich. Auch kann das Luftfilter mit einem leichten bogenförmigen Verlauf im vorderen Teil in einer alternativen Anordnungsform beabstandet zur Bodenfläche des Gehäuses und der Unterseite der Lüfter bis zur Rückseite des Lüftereinschubes geführt sein.

Bei der keilförmigen bzw. schrägen Anordnung des aus hinreichend bekannten Materialien bestehenden Luftfilters ist es zweckmäßig, die vertikale Höhe des Gehäuses mindestens auf die zweifache axiale Erstreckung der Axiallüfter auszulegen, so daß ein ausreichendes Ansaugvolumen für die Lüfter zur Verfügung steht. Die Vergrößerung des Gehäuses in der Höhe erlaubt daher jederzeit auch eine andere Wahl des Neigungswinkels beim Luftfilter.

Auch ist es möglich, insbesondere die hinterste Lüfterreihe mit ihrer Unterfläche etwa im gleichen Neigungswinkel wie das Luftfilter selbst anzuordnen. Die Abstrahlrichtung der Luft erfolgt hierbei zumindest partiell mit der Umlenkungsmöglichkeit auch gegen die Rückwand eines entsprechenden Elektronikschrankes. In ähnlicher Weise können auch die nach vorne vorgesehenen Lüfterreihen mit gleicher oder einem unterschiedlichen Neigungswinkel gegenüber dem Luftfilter bzw. der rückwärtigen Lüfterreihe vorgesehen werden.

Da es sich bei den verwendeten Lüftern um komplette Lüfteraggregate handelt, die körperschallisoliert in die verwendeten Gehäuseschalen eingesetzt werden können, ist es auch möglich, nur einen Teil und bestimmte Lüftungsöffnungen in der Gehäuseoberfläche mit darunter angeschlossenen Lüftern zu besetzen. Die verbleibenden Lüftungsöffnungen können z.B. mittels eines Schaumstoffblockes weitgehend luftdicht abgeschlossen werden. Diese Möglichkeit eröffnet es, noch gezielter vertikal über dem Lüftereinschub vorhandene Wärmenester zu kühlen.

Im Hinblick auf größtmögliche Variabilität ist der gesamte Lüftereinschub meist mehrreihig mit Lüftungsöffnungen in der oberen Gehäusefläche ausgestattet. Diese Lüftungsöffnungen sind zweckmäßigerweise weitgehend gleichmäßig beabstandet in der gesamten Tiefe und Breite der Gehäusefläche vorgesehen, so daß eine ganzflächige Kühlwirkung mit diesem Lüftereinschub erreicht werden kann.

Im Hinblick auf eine einfache Austauschbarkeit werden schräg an den Gehäuseseiten verlaufende Führungsschienen vorgesehen, in die rahmenartige Filterflächen leicht eingeschoben und herausgenommen werden können.

Die Erfindung wird nachstehend anhand eines Ausführungsbeispieles noch näher erläutert, wobei zur Verdeutlichung auch der Stand der Technik dargestellt ist. Es zeigen:
- Fig. 1: Eine Draufsicht auf die Gehäuseoberfläche eines Lüftereinschubes nach dem Stand der Technik mit Frontansaugung und vertikal abstrahlenden Axiallüftern;
- Fig. 2: schematisch einen Schnitt in Längsrichtung des nach Fig. 1 gezeigten Lüftereinschubes mit beutelartigem Luftfilter im Frontbereich;
- Fig. 3: eine Draufsicht auf einen erfindungsgemäßen Lüftereinschub in ähnlicher Ausbildung wie ein Lüftereinschub nach Fig. 1;
- Fig. 4: einen Längsschnitt durch den erfindungsgemäßen Lüftereinschub nach Fig. 3 und
- Fig. 5: einen Längsschnitt durch ein vergleichbares Gehäuse wie nach Fig. 4, jedoch ohne Lüfter.

Der in Draufsicht in Fig. 1 schematisch dargestellte Lüftereinschub entspricht dem Stand der Technik. Dieser bekannte frontseitig über die Ansaugöffnung 3 ansaugende Lüftereinschub 1 weist im rückwärtigen Bereich seiner oberen Gehäusefläche vier Luftaustrittsöffnungen mit kreisförmigem Querschnitt auf. Diese Luftaustrittsöffnungen sind mit einem Lüftungsgitter 7, das integriert mit der Gehäuseschale hergestellt sein kann, ausgestattet. Den einzelnen Luftaustrittsöffnungen 6 ist ein Axiallüfter 8 zugeordnet, der die weitgehend horizontal angesaugte Luft nach Umlenkung um 90° vertikal in ein zu kühlendes Gerät einbläst.

Das etwa zweifache oder mehrfache Höhe der Axiallüfter 8 aufweisende Gehäuse 2 ist im Inneren an der Frontseite mit einem Luftfilter 4 ausgestattet. Die angesaugte Luft wird dadurch gereinigt, so daß weitgehend staubfreie Luft zur Kühlung axial abgeblasen wird. Durch das konkav bzw. beutelartig in das Gehäuseinnere hineinragende Luftfilter konnte die Filterfläche im Vergleich zu der Frontfläche bzw. der Fläche der Ansaugöffnung über die gesamte Höhe und Breite des Gehäuses erheblich vergrößert werden. Strömungsdynamisch scheint diese beutelartige Konfiguration der Luftfilter jedoch bisher dazu geführt zu haben, daß die Lüfter 8 allein im rückwärtigen Bereich, also im wesentlichen in der rückwärtigen Hälfte, vorgesehen worden sind. Im Beispiel nach den Fig. 1 und 2 sind zwei Reihen mit jeweils zwei Lüftern 8 vorhanden. Lüftereinschübe 1 dieser Art weisen an der Frontplatte bzw. am Frontrahmen beidseitig Griffe 9 auf, um eine einfache Handhabung des Lüftereinschubes zu gewährleisten.

Im Gegensatz zu der Ausführungsform nach den Fig. 1 und 2 ist in den Fig. 3 bis 5 eine erfindungsgemäße Ausführungsform eines Lüftereinschubes dargestellt. Gleiche Bezugszeichen bezeichnen daher gleiche Gegenstände wie nach den Fig. 1 und 2. Auch wurde zum besseren Vergleich mit dem bekannten Lüftereinschub beim erfindungsgemäßen Lüftereinschub eine ähnliche Konfiguration gewählt.

In der Draufsicht nach Fig. 3 weist der erfindungsgemäße Lüftereinschub 6 über die gesamte Gehäuseoberfläche 16 weitgehend gleichmäßig verteilte Luftaustrittsöffnungen 6 auf. In der Tiefe des Gehäuses 12 des Lüftereinschubes 10 sind dabei drei Reihen zu jeweils zwei Lüftern 8 bzw. 11 vorgesehen.

Im Längsschnitt nach Fig. 4 ist erkennbar, daß das Luftfilter 14 in einer schrägen Ebene, die etwa von der Oberkante der Ansaugöffnung 13 bis in die Mitte des Gehäusebodens 18 reicht, angeordnet ist. Die rückwärtigen zwei Reihen der Lüfter 8 entsprechen dabei dem Stand der Technik. Erfindungsgemäß kann jedoch bei der vorgesehenen Luftfilteranordnung im vordersten Bereich, dicht benachbart zur Frontseite und dem Luftfilter, eine weitere Reihe von zwei Lüftern 11 angeordnet werden. Dies ermöglicht es, einen erfindungsgemäßen Lüftereinschub auch zur Wärmeableitung und Kühlung im Frontbereich eines entsprechenden Elektronikschrankes einzusetzen, wo man bisher Querstromgebläse mit Radiallüftern verwenden mußte. Der nach Fig. 4 keilförmige Ansaugbereich 15 erstreckt sich im Beispiel in der Tiefe über die ersten beiden Reihen der Lüfter 11 und 8. Die frontseitige Ansaugöffnung 13 reicht üblicherweise über die gesamte Breite und Höhe des Gehäuses, um eine große Ansaugfläche für die Lüfter 8, 11 realisieren zu können.

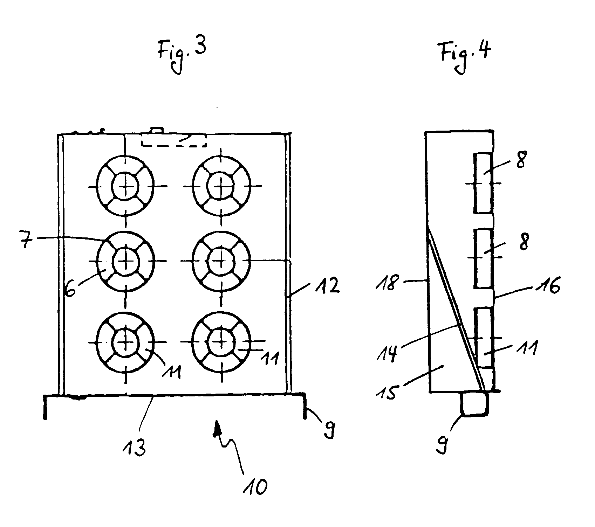

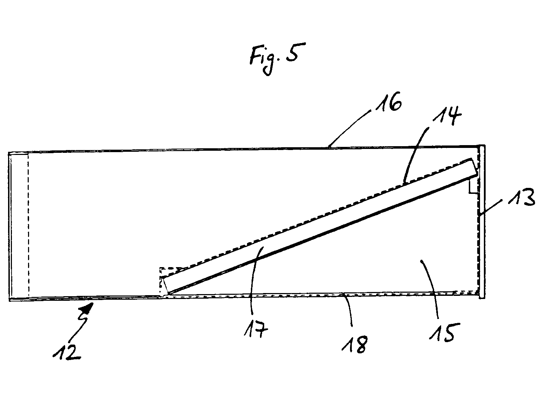

In Fig. 5 ist ein Längsschnitt, vergleichbar dem nach Fig. 4, jedoch ohne Lüfter 8 dargestellt. Das mit einem Rahmen bzw. mit Außenschienen üblicherweise ausgestattete Luftfilter 14 wird dabei über U-förmige Führungsschienen 17, die auf den Innenseiten des Gehäuses vorgesehen sind, gehaltert. Diese Führungsschienen 17 reichen vom oberen Bereich der Ansaugöffnung 13 über die Mitte des Gehäusebodens 18 hinaus in das Innere des Gehäuses 12.

Die erfindungsgemäßen Lüftereinschübe eignen sich daher in der vorliegenden Form auch zur Kühlung von kritischen Baugruppen im frontseitigen Bereich des entsprechenden Gehäuses bzw. des Schrankes. Die Einsatzmöglichkeiten werden dadurch und insbesondere unter Berücksichtigung einer gezielt lokalisierten Lüfteranordnung, wobei andere Lüftungsöffnungen luftdicht abgeschlossen werden, noch erheblich verbessert.

## Patentansprüche

1. Lüftervorrichtung, insbesondere Lüftereinschub mit horizontaler Frontansaugung und vertikaler Luftabstrahlung, mit einem Gehäuse, das eine über die Gehäusebreite reichende Frontansaugöffnung aufweist, der im Luftstrom im wesentlichen über die gesamte Ansaugfläche ein Luftfilter nachgeordnet ist, das in einer schrägen, vom oberen Bereich der Frontansaugöffnung in das Gehäuse hineinlaufenden Ebene bis zum Gehäuseboden vorgesehen ist, und mit mindestens einer in der oberen Gehäusefläche vorgesehenen Luftaustrittsöffnung, der Axiallüfter zugeordnet sind,
dadurch **gekennzeichnet**,
daß im wesentlichen über die gesamte Breite und Tiefe der oberen Gehäusefläche (16) verteilt Luftaustrittsöffnungen (6) vorgesehen sind,
daß jedem Axiallüfter (11) eine separate Luftaustrittsöffnung (6) in der oberen Gehäusefläche (16) zugeordnet ist,
daß die Achsen der Axiallüfter (8,11) im wesentlichen vertikal zur oberen Gehäusefläche (16) angeordnet sind und
daß der vorderste Axiallüfter (11) oder die vorderste Reihe von Axiallüftern (11,11) dicht benachbart zur Frontansaugöffnung (13) und dem Luftfilter (14) angeordnet ist.

2. Lüftervorrichtung nach Anspruch 1,
dadurch **gekennzeichnet,**
daß die im wesentlichen über die gesamte Breite und Tiefe der oberen Gehäusefläche (16) verteilten Luftaustrittsöffnungen (6) weitgehend gleichmäßig beabstandet sind.

3. Lüftervorrichtung nach Anspruch 1 oder 2,
dadurch **gekennzeichnet,**
daß nur einem Teil der Luftaustrittsöffnungen (6) ein Lüfter (8) zugeordnet ist und der verbleibende Teil im wesentlichen luftdicht abschließbar ist.

4. Lüftervorrichtung nach einem der Ansprüche 1 bis 3,
dadurch **gekennzeichnet,**
daß relativ flache Axiallüfter (8,11) vorgesehen sind.

5. Lüftervorrichtung nach einem der Ansprüche 1 bis 4,
dadurch **gekennzeichnet,**
daß die vertikale Höhe des Gehäuses (12) mindestens der zweifachen axialen Höhe der Lüfter (8,11) entspricht.

6. Lüftervorrichtung nach einem der Ansprüche 1 bis 5,
dadurch **gekennzeichnet,**
daß das Luftfilter (14) mindestens die vordere Hälfte der Gehäusetiefe überdeckt.

7. Lüftervorrichtung nach einem der Ansprüche 1 bis 6,
dadurch **gekennzeichnet,**
daß das Luftfilter (14) über Führungen (17) austauschbar gehaltert ist.

## Claims

1. Fan means, particularly a fan slide-in unit with horizontal frontal suction and vertical air emission, with a casing, which has a frontal suction opening extending over the casing width and which is followed in the air flow and substantially over the entire suction surface by an air filter, which is provided in an inclined plane extending from the upper area of the frontal suction opening in the casing to the casing base and with at least one air outlet provided in the upper casing surface associated with axial-flow fans,
**characterized** in
that air outlets (6) are distributed over substantially the entire width and depth of the upper casing surface (16),
that with each axial-flow fan (11) is associated a separate air outlet (6) in the upper casing surface (16),
that the axes of the axial-flow fans (8, 11) are substantially vertical to the upper casing surface (16) and that the foremost axial-flow fan (11) or the foremost row of axial-flow fans (11, 11) are arranged very close to the frontal suction opening (13) and the air filter (14).

2. Fan means according to claim 1,
**characterized** in
that the air outlets (6) distributed substantially over the entire width and depth of the upper casing surface (16) are substantially uniformly spaced.

3. Fan means according to claims 1 or 2,
**characterized** in a
that a fan (8) is only associated with part of the air outlets (6) and the remaining part can be sealed in substantially airtight manner.

4. Fan means according to one of the claims 1 to 3,
**characterized** in
that relatively flat axial-flow fans (8, 11) are provided.

5. Fan means according to one of the claims 1 to 4,
**characterized** in
that the vertical height of the casing (12) corresponds to at least twice the axial height of the fans (8, 11).

6. Fan means according to one of the claims 1 to 5,
**characterized** in
that the air filter (14) at least covers the front half of the casing depth.

7. Fan means according to one of the claims 1 to 6,
**characterized** in
that the air filter (14) is retained in interchangeable manner by means of the guides (17).

## Revendications

1. Dispositif de ventilateurs, notamment ventilateur encastrable avec aspiration frontale horizontale et déviation verticale de l'air, avec un capotage qui présente un orifice d'aspiration frontale s'étendant sur toute la largeur du capotage, avec un filtre à air disposé essentiellement sur toute la surface d'aspiration, prévu dans un plan s'étendant obliquement vers l'intérieur du capotage depuis le domaine supérieur de l'orifice d'aspiration frontal jusqu'au fond du capotage et avec au moins une sortie d'air prévue à la surface supérieure de capotage correspondant au ventilateur axial,
**caractérisé** en ce
qu'on prévoit des orifices de sortie d'air (6) répartis essentiellement sur toute la largeur et la profondeur de la surface supérieure (16) du capotage, qu'à chaque ventilateur axial (11) correspond un orifice de sortie d'air (6) séparé dans la surface supérieure (16) de capotage, que les axes du ventilateur axial (8, 11) sont disposés essentiellement verticalement par rapport à la surface supérieure de capotage (16) et que le premier ventilateur axial (11) ou la première rangée de ventilateurs axiaux (11, 11) sont placés tout près de l'orifice d'aspiration frontale (13) et du filtre d'air (14).

2. Dispositif de ventilateurs selon la revendication 1,
**caractérisé** en ce
que les orifices de sortie d'air (6) répartis essentiellement sur toute la largeur et la profondeur de la surface supérieure de capotage (16) sont espacés de manière largement réguliere.

3. Dispositif de ventilateurs selon la revendication 1 ou 2,
**caractérisé** en ce
que seulement une partie des orifices de sortie d'air (6) correspond à un ventilateur (8) et que la partie restante est obturable de manière essentiellement étanche a l'air.

4. Dispositif de ventilateurs selon l'une des revendications 1 à 3,
**caractérisé** en ce
qu'on prévoit des ventilateurs axiaux (8, 11) relativement plats.

5. Dispositif de ventilateurs selon l'une des revendications 1 à 4,
**caractérisé** en ce
que le hauteur verticale du capotage (12) correspond au moins à deux fois la hauteur axiale des ventilateurs (8, 11).

6. Dispositif de ventilateurs selon l'une des revendications 1 à 5,
**caractérisé** en ce
que le filtre à air (14) recouvre au moins la moitié antérieure de la profondeur de capotage.

7. Dispositif de ventilateurs selon l'une des revendications 1 à 6,
**caractérisé** en ce
que le filtre à air (14) est maintenu de manière amovible sur des glissières (17).
